# EUROPEAN PATENT APPLICATION

(11) **EP 4 503 102 A1**
(43) Date of publication of application: **05.02.2025**
(21) Application number: 23780404.2
(22) Date of filing: 27.03.2023
(51) Int. Cl.: H01L 21/52, H01L 21/50

(54) **TRANSFER DEVICE AND TRANSFER METHOD**

(30) Priority: 28.03.2022 JP 2022051687
(71) Applicant: Toray Engineering Co., Ltd., Tokyo 103-0028 (JP)
(72) Inventor: KAZAMA, Koichi, Otsu-shi, Shiga 520-0842 (JP); OKADA, Tatsuya, Otsu-shi, Shiga 520-0842 (JP); JINDA, Toshiyuki, Otsu-shi, Shiga 520-0842 (JP); ARAI, Yoshiyuki, Otsu-shi, Shiga 520-0842 (JP)
(74) Representative: Global IP Europe Patentanwaltskanzlei
(86) International application number: PCT/JP2023/012307
(87) International publication number: WO 2023/190395

(57) **Abstract**

To provide a transfer device and a transfer method with which it is possible to reliably cause an element to detach from a transfer substrate and be transferred to a receiving substrate. Specifically, a transfer substrate 22 comprises a blistering layer 24 in which a blister 30 is generated by irradiation of an active energy ray, an element 21 is held by the blistering layer 24, a receiving substrate 23 comprises a capture layer 25 that can hold the element 21, the capture layer 25 is arranged facing the transfer substrate 22, and an energy irradiation unit 12 forms the blister 30 in an element holding area 24a, which is an area of the blistering layer 24 that holds one element 21, to change a tilt of the element 21 relative to the transfer substrate 22 and to bring the element 21 closer to the receiving substrate 23, thereby causing the a portion of the element 21 to come in contact with the capture layer 25 first, in a state in which the blistering layer 24 holds the element 21.

## Description

### [TECHNICAL FIELD]

The present invention relates to a transfer device and a transfer method for irradiating light energy on a transfer substrate and using blistering to transfer an element onto a receiving substrate.

### [BACKGROUND ART]

In recent years, semiconductor chips have been reduced in size for the purpose of cost reduction, and efforts are being made to mount such miniaturized semiconductor chips with high precision. A so-called laser lift-off method has been employed to mount such miniaturized chips at a high speed, in which laser is irradiated on a bonding surface of a chip bonded to a transfer substrate to cause ablation, which causes the chip to detach from the transfer substrate and be biased, thereby being transferred onto a receiving substrate.

Patent Document 1 discloses an element transfer device that uses the ablation technique to transfer an element. In this element transfer device, a laser irradiation device, having a laser light source for generating a laser beam, a reflection means for reflecting the laser beam from the laser light source in a required direction, and a control means for controlling irradiation and non-irradiation of the laser beam in conjunction with the reflection means, is used to selectively irradiate the laser beam on some of a plurality of elements arranged on a transfer substrate to cause ablation in a layer holding the elements. This selective ablation causes some of the elements to be transferred onto the receiving substrate. That is, the elements are transferred from the transfer substrate to the receiving substrate by laser lift-off.

In addition, Patent Document 2 discloses a technique in which a laser beam is irradiated on a blistering layer that is provided on a transfer substrate and that has an adhesive layer on the front surface side, to generate a blister (bulge) in the blistering layer, and an object (element) that is adhered to this adhesive layer is pushed out as a result of the generation of this blister, thereby separating the object from the transfer substrate.

### [PRIOR ART DOCUMENT]

### [PATENT DOCUMENTS]

[Patent Document 1] Japanese Laid-Open Patent Application Publication No. 2006-041500
[Patent Document 2] Japanese Translation of PCT International Application Publication No. 2014-515883

### [SUMMARY OF THE INVENTION]

### [PROBLEM TO BE SOLVED BY THE INVENTION]

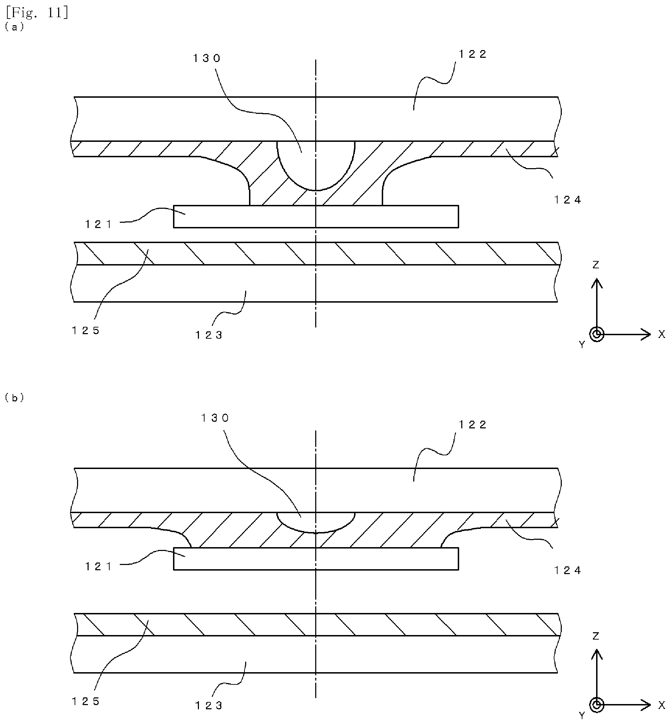

However, in the element transfer devices disclosed in Patent Documents 1 and 2, the force with which the transfer substrate (transfer source substrate) holds the element may stay stronger than the force with which the element is separated even after the laser irradiation, so there is a risk that the element is not detached from the transfer substrate. In particular, if a blister is generated, due to ablation, in a portion of the transfer substrate that holds an element, even if one blister 130 is generated by irradiating laser on a blistering layer 124 that holds one element 121 on a transfer substrate 122, as shown in Figure 11, the contact area between the blistering layer 124 and the element 121 remains large, so that the force (for example, adhesive force) with which the element 121 is held on this contact surface is stronger than the force (for example, gravity or kinetic energy accompanying the generation of the blister) for separating the element 121; as a result, there is the possibility that the element 121 does not detach from the transfer substrate 122. As a result, there is the problem that the element 121 is not transferred to a receiving substrate 123, which has a capture layer 125, and returns to the transfer substrate 122 as the blister 130 shrinks.

In view of the problem described above, an object of the present invention is to provide a transfer device and a transfer method with which it is possible to reliably cause an element to detach from a transfer substrate and be transferred to a receiving substrate.

### [MEANS TO SOLVE THE PROBLEMS]

In order to solve the problem described above, a transfer device of the present invention is a transfer device configured to transfer an element held on a transfer substrate to a receiving substrate, the transfer device comprising an energy irradiation unit configured to irradiate an active energy ray toward the element through the transfer substrate in a state in which the transfer substrate and the receiving substrate face each other across the element, the transfer substrate having a blistering layer in which a blister is generated due to irradiation of the active energy ray and the element being held by the blistering layer, the receiving substrate having a capture layer that can hold the element and the capture layer being arranged facing the transfer substrate, and the energy irradiation unit being configured to form the blister in an element holding area, which is an area of the blistering layer that holds one element, to change a tilt of the element relative to the transfer substrate and to bring the element closer to the receiving substrate, thereby causing a portion of the element to come in contact with the capture layer first, in a state in which the blistering layer holds the element.

According to the transfer device of the present invention, the tilt of the element relative to the transfer substrate is changed and the element is brought closer to the receiving substrate, thereby making it easier for at least a portion of the element to come in contact with the capture layer as compared with bringing the element closer to the receiving substrate while maintaining a state in which the element is parallel with the transfer substrate, so that the element can be transferred onto the receiving substrate starting from that point.

In addition, the blister preferably shrinks over time.

As a result, the blistering layer naturally detaches from the element that has come in contact with the capture layer, without having to wait for the transfer substrate and the receiving substrate to separate from each other.

In addition, the blister is preferably formed such that a center of the blister is positioned at a peripheral portion of the element holding area other than a center thereof.

As a result, even if only one blister is formed, it is possible to create a state in which the element is tilted with respect to the transfer substrate.

Preferably, at least two of the blisters are formed in sequence in the element holding area.

As a result, it is possible to stably maintain a state in which the element is tilted relative to the transfer substrate.

In addition, preferably, when a large blister and a small blister having different volumes are formed in the element holding area, the small blister is formed first, and, in a state in which the element is tilted by the small blister, the large blister is formed where a gap between the transfer substrate and the element is smaller than that of a location where the small blister is formed.

As a result, a portion of the element is detached from the blistering layer due to the formation of the small blister before a large tilt is generated due to the large blister, so it is possible to reduce load that is applied to the element at the time of the large blister formation.

In addition, three or more blisters, each having a different volume, are preferably formed in the element holding area so as to be arranged in order of volume.

As a result, it is possible to more stably maintain a state in which the element is tilted relative to the transfer substrate.

In addition, preferably, a large blister and a small blister having different volumes are formed in the element holding area so as to be connected to each other, and gas inside the small blister moves into the large blister so that the large blister expands toward the receiving substrate.

As a result, as the large blister expands toward the receiving substrate, the tilt of the element becomes larger than prior to the expansion and the entire element further approaches the capture layer, so that the element can more reliably be transferred to the receiving substrate.

In addition, the large blister and the small blister are preferably connected via a thin linear blister.

As a result, it is possible to easily create a state in which the large blister and the small blister are connected to each other.

In addition, in order to solve the problem described above, a transfer device of the present invention is a transfer device configured to transfer an element held on a transfer substrate to a receiving substrate, the transfer device comprising an energy irradiation unit configured to irradiate an active energy ray toward the element through the transfer substrate in a state in which the transfer substrate and the receiving substrate face each other across the element, the transfer substrate having a blistering layer in which a blister is generated due to irradiation of the active energy ray and the element being held by the blistering layer, the receiving substrate having a capture layer that can hold the element and the capture layer being arranged facing the transfer substrate, and the energy irradiation unit being configured to form a large blister and a small blister having different volumes in an element holding area, which is an area of the blistering layer that holds one element, so as to be connected to each other, and gas inside the small blister moving into the large blister so that the large blister expands toward of the receiving substrate, thereby causing the element to come in contact with the capture layer in a state in which the blistering layer holds the element.

According to the transfer device of the present invention, as the large blister expands toward the receiving substrate, the entire element comes closer to the capture layer than prior to the expansion, so that the element can more reliably be transferred to the receiving substrate.

In addition, in order to solve the problem described above, a transfer method of the present invention is a transfer method for transferring an element held on a transfer substrate to a receiving substrate, the transfer method comprising an energy irradiation step for irradiating an active energy ray toward the element through the transfer substrate in a state in which the transfer substrate and the receiving substrate face each other across the element, to cause the element to detach from the transfer substrate and move to the receiving substrate, the transfer substrate having a blistering layer in which a blister is generated due to irradiation of the active energy ray and the element being held by the blistering layer, the receiving substrate having a capture layer that can hold the element and the capture layer being arranged facing the transfer substrate, and in the energy irradiation step, the blister being formed in an element holding area, which is an area of the blistering layer that holds one element, to change a tilt of the element relative to the transfer substrate and to bring the element closer to the receiving substrate, thereby causing a portion of the element to come in contact with the capture layer first in a state in which the blistering layer holds the element.

According to the transfer method of the present invention, the tilt of the element relative to the transfer substrate is changed and the element is brought closer to the receiving substrate, thereby making it easier for at least a portion of the element to come in contact with the capture layer as compared with bringing the element closer to the receiving substrate while maintaining a state in which the element is parallel with the transfer substrate, so that the element can be transferred onto the receiving substrate starting from that point.

In addition, in order to solve the problem described above, a transfer method of the present invention is a transfer method for transferring an element held on a transfer substrate to a receiving substrate, the transfer method comprising an energy irradiation step for irradiating an active energy ray toward the element through the transfer substrate in a state in which the transfer substrate and the receiving substrate face each other across the element, to cause the element to detach from the transfer substrate and move to the receiving substrate, the transfer substrate having a blistering layer in which a blister is generated due to irradiation of the active energy ray and the element being held by the blistering layer, the receiving substrate having a capture layer that can hold the element and the capture layer being arranged facing the transfer substrate, and in the energy irradiation step, a large blister and a small blister having different volumes being formed in an element holding area, which is an area of the blistering layer that holds one element, so as to be connected to each other, and gas inside the small blister moving into the large blister so that the large blister expands toward the receiving substrate, thereby causing the element to come in contact with the capture layer in a state in which the blistering layer holds the element.

According to the transfer method of the present invention, as the large blister expands toward the receiving substrate, the entire element comes closer to the capture layer than prior to the expansion, so that the element can more reliably be transferred to the receiving substrate.

### [EFFECTS OF THE INVENTION]

According to the transfer device and the transfer method of the present invention, it is possible to reliably cause an element to detach from a transfer substrate and be transferred to a receiving substrate.

### [BRIEF DESCRIPTION OF THE DRAWINGS]

[Figure 1] is a diagram for explaining a transfer device according to one embodiment of the present invention.
[Figure 2] is a diagram showing a transfer substrate and a receiving substrate before transfer of an element in the present invention.
[Figure 3] is a diagram for explaining one embodiment of a transfer method using the transfer device of the present invention.
[Figure 4] is a diagram showing the transfer substrate and the receiving substrate after a prescribed period of time has elapsed after irradiation of an active energy ray.
[Figure 5] is a diagram for explaining a transfer method according to another embodiment of the present invention.
[Figure 6] is a diagram for explaining a transfer method according to another embodiment of the present invention.
[Figure 7] is a diagram for explaining a process by which the shape of a blister changes in the transfer method of Figure 6.
[Figure 8] is a diagram for explaining a transfer method according to another embodiment of the present invention.
[Figure 9] is a diagram for explaining a transfer method according to another embodiment of the present invention.
[Figure 10] is a diagram for explaining a transfer method according to another embodiment of the present invention.
[Figure 11] is a diagram for explaining an example in which transfer of an element failed in a conventional transfer method.

### [EMBODIMENTS TO CARRY OUT THE INVENTION]

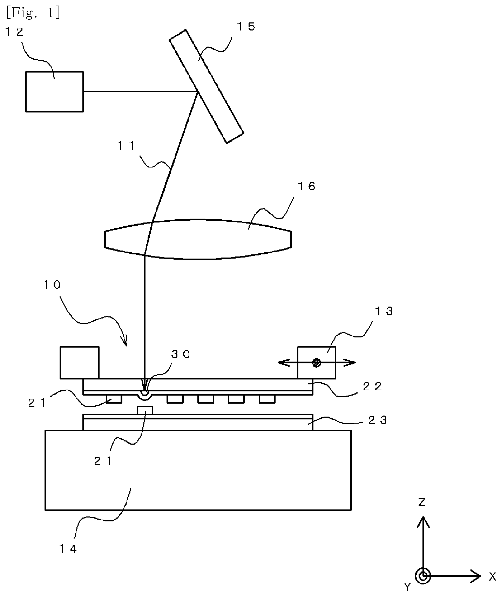

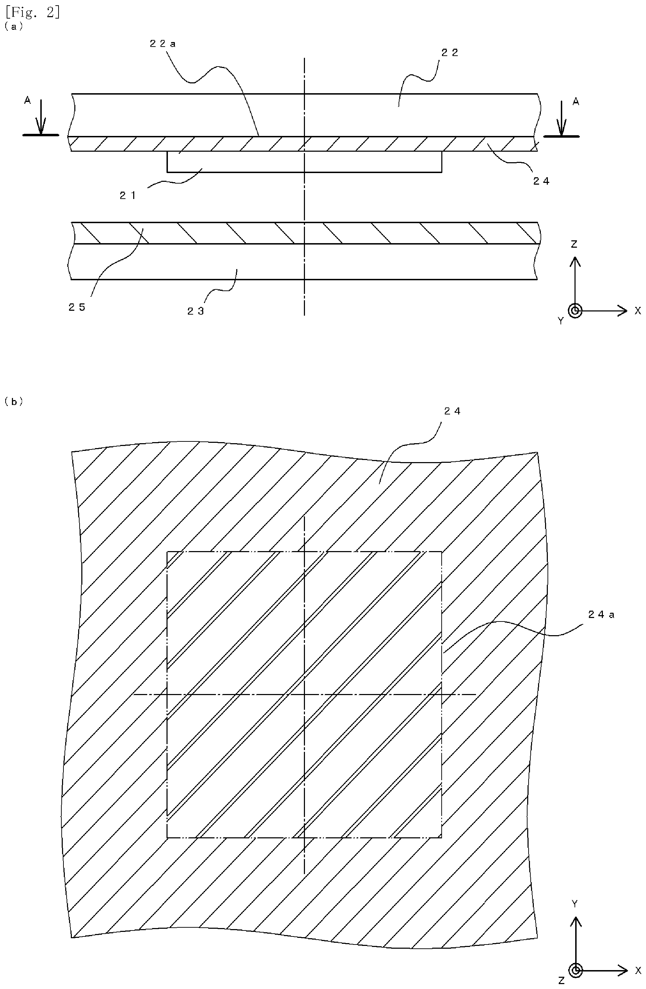

A transfer device according to one embodiment of the present invention will be described, with reference to Figures 1 and 2. Figure 1 is a diagram for explaining a transfer device according to one embodiment of the present invention, Figure 2 is a diagram showing a transfer substrate and a receiving substrate before transfer of an element in the present invention, Figure 2(a) is a front view, and Figure 2(b) is a view in the arrow direction of the AA line in Figure 2(a).

The transfer device 10 comprises a laser irradiation unit 12 that irradiates laser light 11, a transfer substrate holding unit 13 that can hold and move a transfer substrate 22 at least in an X-axis direction and a Y-axis direction, a receiving substrate holding unit 14 that is below the transfer substrate holding unit 13 and holds a receiving substrate 23 so as to face the transfer substrate 22 with a gap therebetween, and an undiagrammed control unit. The transfer device 10 irradiates the laser light 11 onto the transfer substrate 22 to cause ablation in the transfer substrate, thereby transferring an element 21 from the transfer substrate 22 to the receiving substrate 23.

The laser irradiation unit 12 is one embodiment of an energy irradiation unit in the present invention, is a device that irradiates the laser light 11, such as an excimer laser, which is an active energy ray, and is provided fixed to the transfer device 10. In the present embodiment, the laser irradiation unit 12 irradiates the spot-shaped laser light 11, the irradiation position of the laser light 11 in the X-axis direction and the Y-axis direction is controlled via an f0 lens 16 and a galvano mirror 15 whose angle is adjusted by a control unit, and the laser light 11 selectively irradiates a plurality of the elements 21 arranged on the transfer substrate 22 held by the transfer substrate holding unit 13. When the laser light 11 enters near the element 21 through the transfer substrate 22, ablation occurs between the transfer substrate 22 and the element 21 due to the application of active energy (light energy). This ablation biases the element 21, and the element 21 is transferred from the transfer substrate 22 to the receiving substrate 23. In this description, the element 21 is, for example, a semiconductor chip.

The transfer substrate holding unit 13 has an opening, and uses suction to hold the vicinity of the outer periphery of the transfer substrate 22. It is possible to irradiate the laser light 11 that is emitted from the laser irradiation unit 12 onto the transfer substrate 22, which is held by the transfer substrate holding unit 13, via this opening.

The transfer substrate 22 is a substrate made of glass, or the like, that can transmit the laser light 11, and that holds the element 21 on the bottom surface side thereof. In addition, a blistering layer 24 is formed on the surface of the transfer substrate 22 that holds the element 21, as shown in Figure 2(a), and the surface of this blistering layer 24 has adhesiveness. The adhesive force of this surface of the blistering layer 24 serves as the holding force for the element 21, thereby adhesively holding the element 21.

In addition, the transfer substrate holding unit 13 is moved, by an undiagrammed movement mechanism, relative to the receiving substrate holding unit 14 in at least the X-axis direction and the Y-axis direction. As a result of an undiagrammed control unit controlling this movement mechanism and adjusting the position of the transfer substrate holding unit 13, it is possible to adjust the relative position of the element 21 held by the transfer substrate 22 relative to the receiving substrate 23.

The receiving substrate holding unit 14 has a flat upper surface, and, during the transfer step of the element 21, holds the receiving substrate 23 such that blistering layer 24 of the transfer substrate 22 and the element 21 held by the blistering layer 24 face the receiving surface of the receiving substrate 23. A plurality of suction holes are provided on the upper surface of the receiving substrate holding unit 14, which hold the rear surface of the receiving substrate 23 (the surface on which the element is not transferred) using suction force.

Here, the receiving substrate 23 in the present embodiment is a substrate made of glass, etc., and, as shown in Figure 2(a), a receiving surface (surface on the side that receives the element 21) is provided with a capture layer 25 having adhesiveness, which adhesively holds the element 21 that has been transferred from the transfer substrate 22.

In the present embodiment, only the transfer substrate holding unit 13 is moved in the X-axis direction and the Y-axis direction to move the transfer substrate holding unit 13 and the receiving substrate holding unit 14 relative to each other, but if the dimensions of the receiving substrate 23 are large and the entire surface of the receiving substrate 23 cannot be placed directly below the irradiation range of the laser light 11, the receiving substrate holding unit 14 may also be provided with a movement mechanism in the X-axis direction and the Y-axis direction.

In the transfer device 10 having the configuration described above, the laser light 11 is irradiated toward the element 21 through the transfer substrate 22 in a state in which the transfer substrate 22 and the receiving substrate 23 are facing each other across the element 21, and the laser light 11 is irradiated on the blistering layer 24; the energy of the laser light 11 thereby decomposes a part of the material of the blistering layer 24, generating gas. Due to the decomposition of the material of the blistering layer 24 and the generation of gas, a blister (air bubble) 30 is generated inside the blistering layer 24 or between the blistering layer 24 and the glass surface 22a of the transfer substrate 22, as shown in Figure 1. The phenomenon in which the blister 30 is generated in this manner is referred to as blistering in this description. In addition, the area of the blistering layer 24 where the element 21 is held, as indicated by the double hatching in Figure 2(b), is referred to as an element holding area 24a in this description.

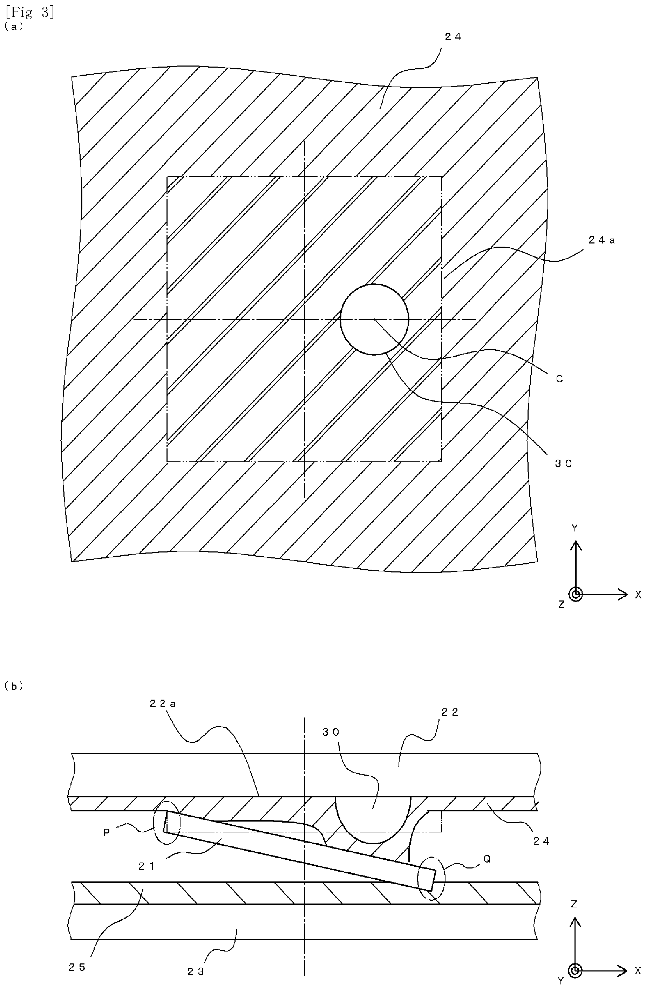

One embodiment of a transfer method using the transfer device of the present invention will be described, with reference to Figure 3. Figure 3(a) shows the state of the blistering layer from the same perspective as the arrow view of Figure 2(a), and Figure 3(b) is a front view including the transfer substrate and the receiving substrate.

As shown in Figure 3(a), the laser light 11, which is an active energy ray, is irradiated on point C in the element holding area 24a of the blistering layer 24, thereby causing blistering in a part of the element holding area 24a centered on point C and forming the blister 30.

The distance between the glass surface 22a and the surface of the adhesive blistering layer 24 where such blistering has occurred is larger than the distance between the surface of the blistering layer 24 and the glass surface 22a before blistering occurs. Therefore, when blistering occurs in the blistering layer 24 in the element holding area 24a, the element 21 separates from the glass surface 22a of the transfer substrate 22 while being held on the surface portion of the blistering layer 24.

In the present embodiment, since the receiving substrate 23 is provided near, and facing, the element 21 with a prescribed gap therebetween, the element 21 approaches the capture layer 25 of the receiving substrate 23 as a result of the occurrence of blistering, while being held on the surface portion of the blistering layer 24.

In the present embodiment, only one of the blister 30 is formed in the element holding area 24a, and the blister 30 is formed such that the center of the blister 30 is positioned at a location other than the center of the element holding area 24a (the dashed-dotted line in Figures 3(a) and 3(b)). As a result, when the element 21 separates from the transfer substrate 22 while being held by the blistering layer 24, the separation takes place as the tilt of the element 21 relative to the transfer substrate 22 changes, as shown in Figure 3(b). In this manner, if the element 21 is tilted with respect to the transfer substrate 22, there will be a portion P of the element 21 that is relatively close to the transfer substrate 22 and a portion Q that is relatively far from the transfer substrate 22, so the portion Q is farther from the transfer substrate 22 than a case in which the blister 30 is formed at the center of the element holding area 24a and the element 21 separates from the transfer substrate 22 while staying parallel thereto. Therefore, the portion Q reaches the capture layer 25 of the receiving substrate 23 first, making the possibility of coming in contact with the capture layer 25 relatively high.

As a result of the portion Q of the element 21 coming in contact with the capture layer 25 first, at least a portion of the element 21 is adhesively held by the capture layer 25. Here, if the adhesive holding strength of the capture layer 25 with respect to the element 21 is larger than the adhesive holding strength of the blistering layer 24 with respect to the element 21, when the capture layer 25 and the blistering layer 24 separate and the capture layer 25 and the blistering layer 24 both pull on the element 21, the blistering layer 24 will detach from the element 21 and the capture layer 25 will hold the entire surface of the element 21. That is, the transfer of the element 21 from the transfer substrate 22 to the receiving substrate 23 is completed.

In this manner, by forming the blister 30 in the element holding area 24a of the blistering layer 24 and causing the element 21 to approach the receiving substrate 23 while being tilted relative to the transfer substrate 22, it becomes easier for at least a portion of the element 21 to come in contact with the capture layer 25 as compared with bringing the element 21 close to the receiving substrate 23 while maintaining a state in which the element 21 is parallel with the transfer substrate 22, so that the element 21 can be transferred onto the receiving substrate 23 starting from that point.

In addition, in the case of a configuration in which the element 21 is brought in contact with the capture layer 25 in a state of being held by the blistering layer 24, as in the present invention, that is, a configuration in which the element 21 is transferred from the transfer substrate 22 to the receiving substrate 23 while constantly being held by something, there is less influence of air resistance and the transfer is carried out with better positional accuracy, as compared with a case in which transfer is carried out by the element being separated from the transfer substrate and falling to the receiving substrate, as is the case with the conventional laser lift-off method.

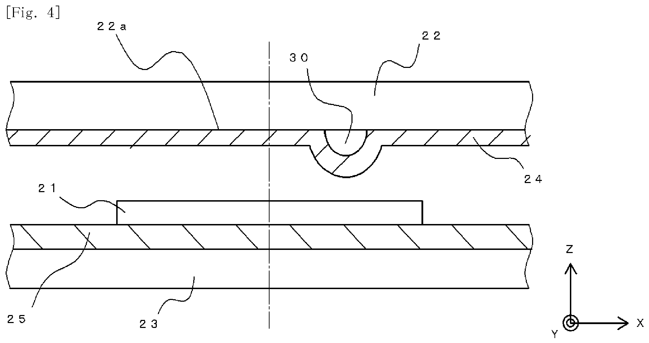

Figure 4 shows the transfer substrate and the receiving substrate after a prescribed period of time has elapsed after irradiation of an active energy ray, as shown in Figure 3.

There are cases in which the blister 30 shrinks, such as when gas, which forms the blister 30 by the irradiation of an active energy ray, contracts due to a decrease in the temperature of the blister 30, or diffuses into the blistering layer 24. In this case, the blistering layer 24 naturally detaches from the element 21 that has come in contact with the capture layer 25 due to the blister 30 shrinking, without having to wait for the transfer substrate 22 and the receiving substrate 23 to separate from each other, after irradiation of the active energy ray on all of the elements 21 on the transfer substrate 22, thereby completing the transfer of the elements 21.

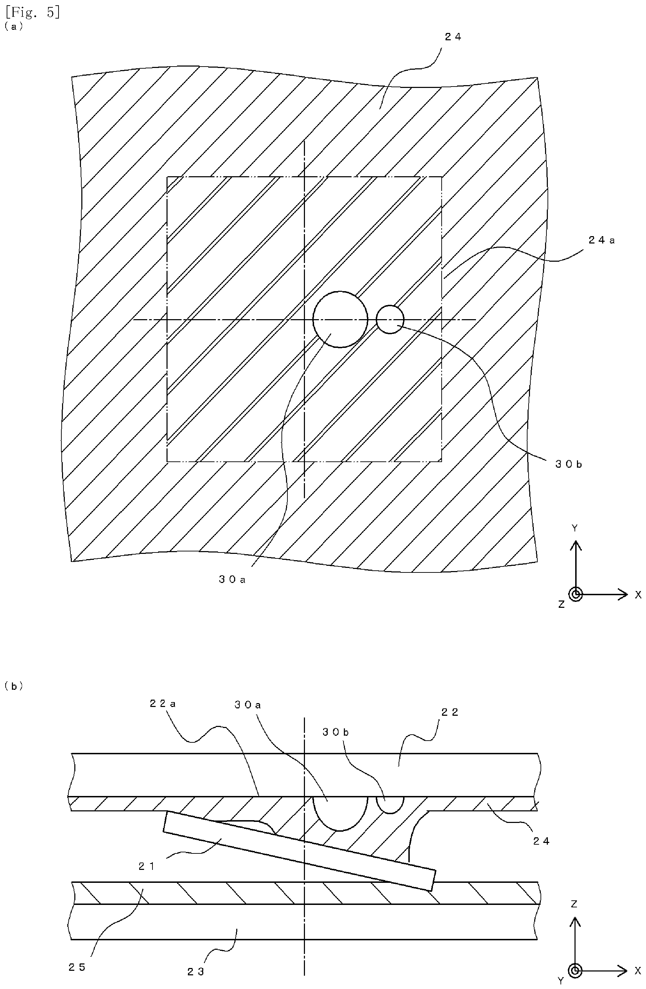

A transfer method according to another embodiment of the present invention will be described next, with reference to Figure 5. Figure 5(a) shows the state of the blistering layer from the same perspective as the arrow view of Figure 2(a), and Figure 5(b) is a front view including the transfer substrate and the receiving substrate.

In the present embodiment, the laser light 11 is irradiated on two locations in the element holding area 24a, forming two blisters (large blister 30a and small blister 30b), and the volume of each blister is different from each other. Blisters having different volumes in this manner can be formed by varying the power, the number of times of the irradiation, etc., of the laser light 11 required for the formation of the blisters. In addition, in the present embodiment, blisters are formed in ascending order of volume.

In this manner, due to the presence of at least two blisters with different volumes, that is, with different heights from the glass surface 22a, the element 21 separates from the glass surface 22a so as to be tilted relative to the transfer substrate 22, and such a separated state can be more stably maintained as compared with a case in which the number of blisters is small.

In addition, in the present embodiment, when forming the large blister 30a and the small blister 30b having different volumes in the element holding area 24a, the small blister 30b is formed first, and, in a state in which the element 21 is tilted by the small blister 30b, the large blister 30a is formed where the gap between the transfer substrate 22 and the element 21 is smaller than that of the location where the small blister 30b is formed, as shown in Figure 5(b). As a result, a portion of the element 21 is detached from the blistering layer 24 due to the formation of the small blister 30b before a large tilt is formed due to the large blister 30a, so it is possible to reduce load that is applied to the element 21 at the time of the large blister 30a formation.

A plurality of blisters may have the same volume. In this case, by sequentially forming blisters in one direction starting from a blister located at the end of the element holding area 24a, the tilt of the element 21 can be increased each time a blister is formed.

Here, the number of blisters to be formed in the element holding area 24a is not limited to two, and may be three or more. In this case, as a result of those blisters being formed in the element holding area 24a so as to be arranged in order of volume, it is possible to more stably maintain a state in which the element 21 is tilted relative to the transfer substrate 22.

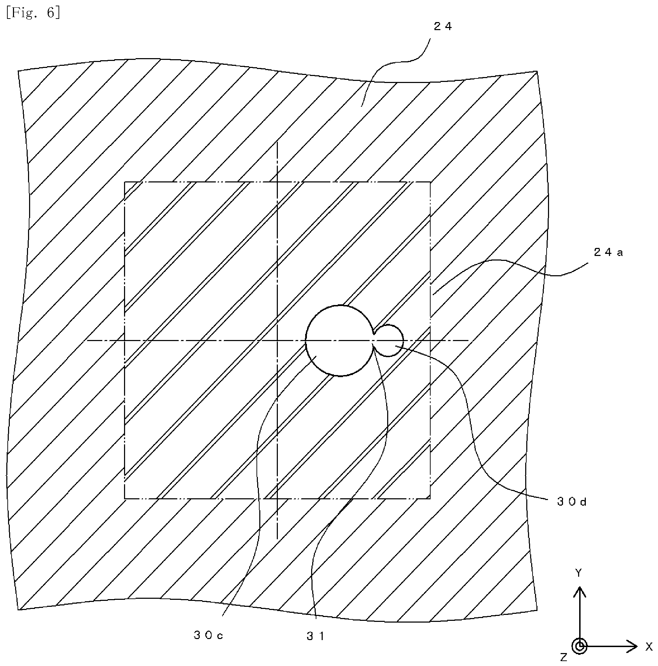

A transfer method according to yet another embodiment of the present invention will be described next, with reference to Figure 6.

In the present embodiment, two blisters (large blister 30c and small blister 30d) having different volumes are formed in the element holding area 24a. The large blister 30c and the small blister 30d are connected with each other at a connecting portion 31. The blistering layer 24 has some elasticity, and the state created by the large blister 30c, the small blister 30d, and the blistering layer 24 surrounding the blisters, is similar to a state in which the openings of two balloons that have been inflated to different sizes are connected to each other.

If the openings of two balloons inflated to different sizes are connected, since the internal pressure of the small balloon is higher than the internal pressure of the large balloon, the small balloon becomes smaller and the gas inside the balloon moves to the large balloon, further increasing the size of the large balloon.

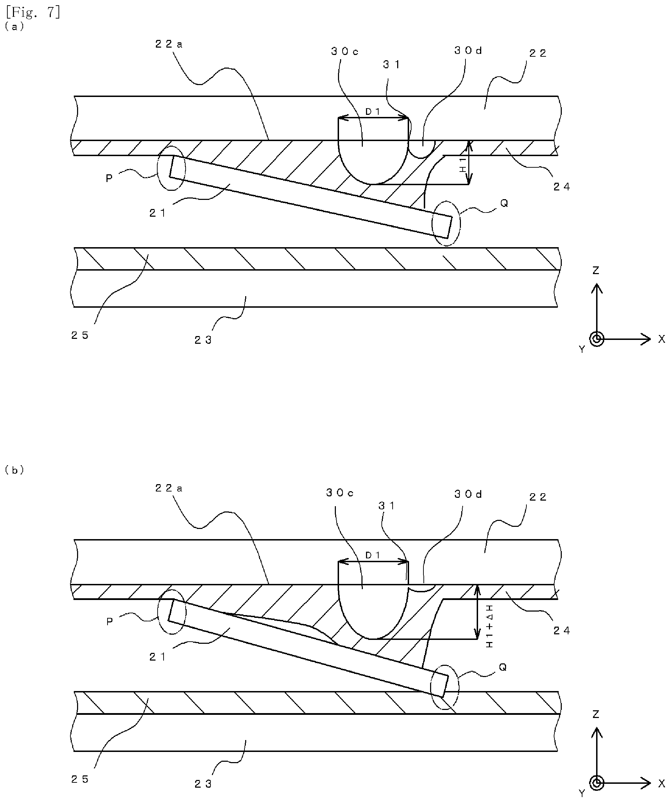

A process by which the shape of a blister changes in the transfer method of the present embodiment will be described, with reference to Figures 7(a) and 7(b). The large blister 30c and the small blister 30d that are connected to each other as in the present embodiment also display the same behavior as the two balloons described above, and, as shown by the transition from Figure 7(a) to Figure 7(b), the gas inside the small blister 30d moves into the large blister 30c, causing the small blister 30d to become smaller and the large blister 30c to become larger.

As a result of the large blister 30c becoming larger, the large blister 30c expands toward the receiving substrate 23, and the height dimension of the large blister 30c changes from H1 to H1+ΔH, as shown in Figure 7(b). Accordingly, the tilt of the element 21 further increases, and, as shown by portion Q in Figure 7(b), a mode is formed in which at least a portion of the element 21 comes in contact with the capture layer 25.

Here, in particular, in the present embodiment, each blister is formed at a boundary between the blistering layer 24 and the glass surface 22a of the transfer substrate 22, as shown in Figure 7, and the bonding strength between the blistering layer 24 and the glass surface 22a is greater than the tensile force of the blistering layer 24 around each blister. In this case, diameter D1 hardly changes as the volume of the large blister 30c increases, and the change in the volume mostly contributes to an increase in height. That is, the aspect ratio of the large blister 30c increases.

As a result of the large blister 30c expanding in the direction in which the aspect ratio increases, the height increase ΔH becomes larger as compared with a case in which the dimensions increase in all directions, so that the tilt of the element 21 can be made even larger. In addition, when forming a blister having a prescribed height dimension, the volume can be kept relatively small, so that the power, the number of times of irradiation, etc., of the laser light 11 to irradiate can be reduced.

In addition, in the present embodiment, when forming the large blister 30c and the small blister 30d having different volumes in the element holding area 24a, the small blister 30d is formed first, and, in a state in which the element 21 is tilted by the small blister 30d, the large blister 30c is formed where the gap between the transfer substrate 22 and the element 21 is smaller than that of the location where the small blister 30b is formed, as shown in Figure 7(a). As a result, the tilt of the element 21 caused by the expansion of the large blister 30c becomes even more pronounced, so that it is possible to reduce the power, the number of times of irradiation, etc., of the laser light 11 required to allow the portion Q of the element 21 to reach the capture layer 25.

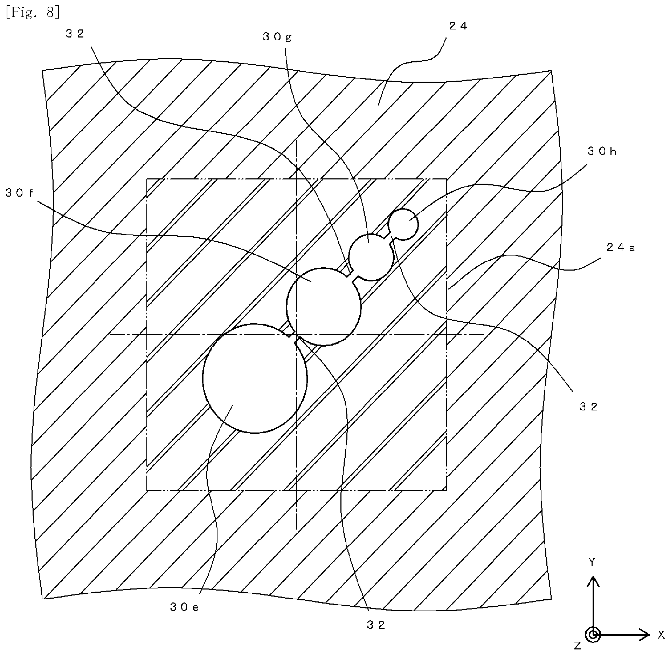

A transfer method according to yet another embodiment of the present invention will be described next, with reference to Figure 8.

In the present embodiment, the laser light 11 is irradiated on the blistering layer 24 forming the element holding area 24a such that four blisters having different volumes, blister 30e, blister 30f, blister 30g, and blister 30h, are formed in order of the volume, along a diagonal line of the element holding area 24a. In addition, adjacent blisters are connected by a connecting portion 32, which is a thin linear blister.

Even when two or more blisters are connected in this manner, in the same manner as in the previous embodiment, gas moves from the small blister to the large blister, so that gas moves from the smallest blister 30h to the second smallest blister 30g, then the gas moves from this blister 30g to the second largest blister 30f, and the gas moves from this blister 30f to the largest blister 30e. Ultimately, the gas of all blisters except for the largest blister 30e contribute to the expansion of the blister 30e, so that the power, the number of times of irradiation, etc., of the laser light 11 can be reduced as compared with a case in which a blister having the same height as the expanded blister 30e is formed of a single blister. The order of formation of the blisters in this case is: the blister 30h, the blister 30g, the blister 30f, the blister 30e, and each of the connecting portions 32.

In addition, by forming a plurality of blisters along a diagonal line, which is the longest possible line segment within the rectangular element holding area 24a, as in the present embodiment, more blisters can be arranged, and the height dimension of the largest blister (blister 30e) can be increased.

Additionally, with a configuration in which thin linear connecting portions 32 are formed by irradiation of the laser light 11 and the blisters are connected to each other by these connecting portions 32, as in the present embodiment, it is possible to easily achieve a configuration in which the blisters are connected to each other.

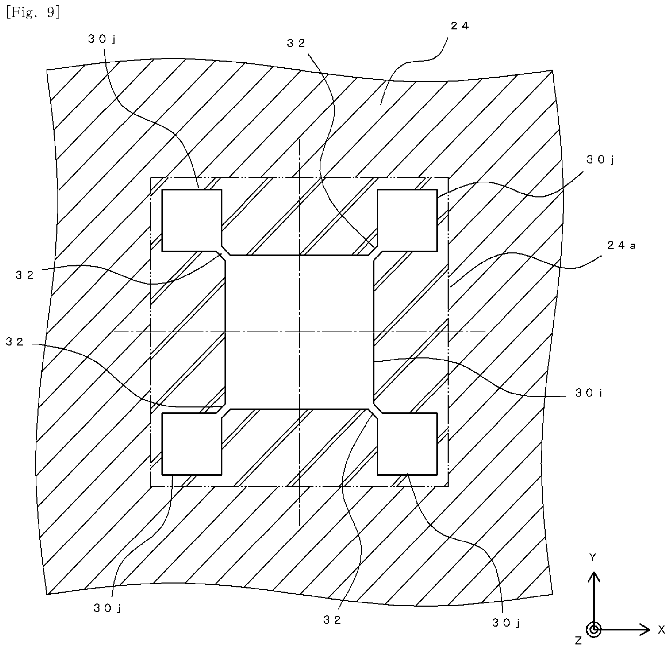

A transfer method according to yet another embodiment of the present invention will be described next, with reference to Figure 9.

In the present embodiment, a largest blister 30i is formed at the center of the element holding area 24a, and blisters 30j are formed at four corners thereof so as to be connected to the blister 30i via the connecting portions 32. In this manner, the blisters do not necessarily need to be connected one-to-one, and a plurality of blisters may be connected to one blister.

Here, in the present embodiment, since the blister 30i is formed at the center of the element holding area 24a, the element 21 will not be tilted relative to the transfer substrate 22, as in the above-mentioned embodiments; however, the blister 30i expands due to the presence of the blisters 30j that supply gas to this blister 30i, so that the element 21 approaches the capture layer 25, increasing the possibility of coming in contact with the capture layer 25.

In addition, in the present embodiment, gas moves from a plurality of the blisters 30j to the blister 30i, so, compared to a case in which there is only one blister 30j, the degrees to which the volume of the blister 30i increases and to which the blister 30j expands toward the receiving substrate 23 become larger. As a result, the element 21 comes closer to the capture layer 25, increasing the possibility of coming in contact with the capture layer 25.

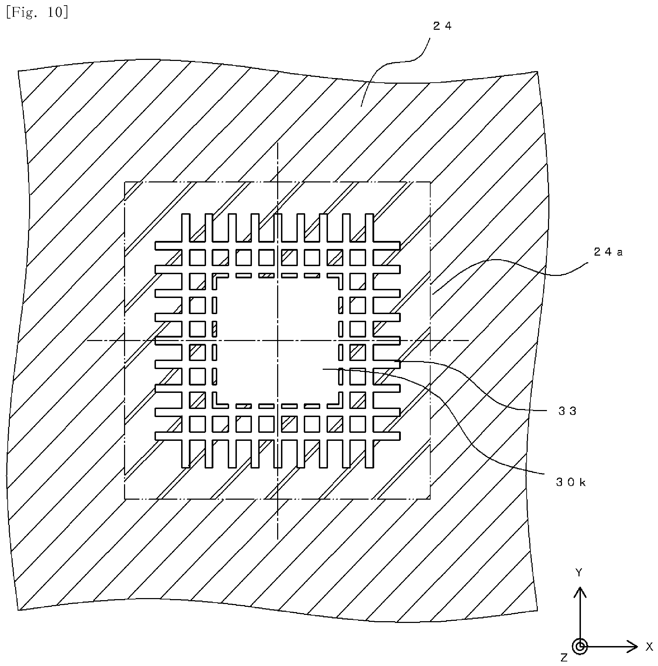

A transfer method according to yet another embodiment of the present invention will be described next, with reference to Figure 10.

In the present embodiment, a blister 30k is formed in the element holding area 24a, and thin linear connection portions 33 are arranged vertically and horizontally so as to be directly or indirectly connected to the blister 30k. Gas can also move from these connected portions 33 to the blister 30k, so that the blister 30k may increase in volume and expand toward the receiving substrate 23.

According to the transfer device and the transfer method described above, it is possible to reliably cause an element to detach from a transfer substrate and be transferred to a receiving substrate.

Here, the transfer device and the transfer method of the present invention are not limited to the embodiments described above, and may take other forms within the scope of the present invention. For example, in the foregoing description, the blistering layer and the capture layer hold the element using adhesive force, but the element may be held by a holding force other than adhesive force.

### [DESCRIPTIONS OF THE REFERENCE SYMBOLS]

10 Transfer device
11 Laser light (active energy ray)
12 Laser light source (energy irradiation unit)
13 Transfer substrate holding unit
14 Receiving substrate holding unit
15 Galvano mirror
16y Fθ lens
21 Element
21a Bump
22 Transfer substrate
22a Glass surface
23 Receiving substrate
24 Blistering layer
24a Element holding area
30, 30e, 30f, 30g, 30h, 30i, 30j, 30k Blisters
30a, 30c Large blisters
30b, 30d small blisters
31 Connecting portion
32 Connecting portion
33 Connecting portion
121 Element
122 Transfer substrate
123 Receiving substrate
124 Blistering layer
125 Capture layer
130 Blister

## Claims

1. A transfer device configured to transfer an element held on a transfer substrate to a receiving substrate, the transfer device comprising:
an energy irradiation unit configured to irradiate an active energy ray toward the element through the transfer substrate in a state in which the transfer substrate and the receiving substrate face each other across the element,
the transfer substrate having a blistering layer in which a blister is generated due to irradiation of the active energy ray and the element being held by the blistering layer,
the receiving substrate having a capture layer that can hold the element and the capture layer being arranged facing the transfer substrate, and
the energy irradiation unit being configured to form the blister in an element holding area, which is an area of the blistering layer that holds one element, to change a tilt of the element relative to the transfer substrate and to bring the element closer to the receiving substrate, thereby causing a portion of the element to come in contact with the capture layer first, in a state in which the blistering layer holds the element.

2. The transfer device according to claim 1, wherein
the blister shrinks over time.

3. The transfer device according to claim 1 or 2, wherein
the blister is formed such that a center of the blister is positioned at a peripheral portion of the element holding area other than a center thereof.

4. The transfer device according to any one of claims 1 to 3, wherein
at least two of the blisters are formed in sequence in the element holding area.

5. The transfer device according to claim 4, wherein,
when a large blister and a small blister having different volumes are formed in the element holding area, the small blister is formed first, and, in a state in which the element is tilted by the small blister, the large blister is formed where a gap between the transfer substrate and the element is smaller than that of a location where the small blister is formed.

6. The transfer device according to claim 4 or 5, wherein
three or more blisters, each having a different volume, are formed in the element holding area so as to be arranged in order of volume.

7. The transfer device according to any one of claims 4 to 6, wherein
a large blister and a small blister having different volumes are formed in the element holding area so as to be connected to each other, and gas inside the small blister moves into the large blister so that the large blister expands toward the receiving substrate.

8. The transfer device according to claim 7, wherein
the large blister and the small blister are connected via a thin linear blister.

9. A transfer device configured to transfer an element held on a transfer substrate to a receiving substrate, the transfer device comprising:
an energy irradiation unit configured to irradiate an active energy ray toward the element through the transfer substrate in a state in which the transfer substrate and the receiving substrate face each other across the element,
the transfer substrate having a blistering layer in which a blister is generated due to irradiation of the active energy ray and the element being held by the blistering layer,
the receiving substrate having a capture layer that can hold the element and the capture layer being arranged facing the transfer substrate, and
the energy irradiation unit being configured to form a large blister and a small blister having different volumes in an element holding area, which is an area of the blistering layer that holds one element, so as to be connected to each other, and gas inside the small blister moving into the large blister so that the large blister expands toward the receiving substrate, thereby causing the element to come in contact with the capture layer, in a state in which the blistering layer holds the element.

10. A transfer method for transferring an element held on a transfer substrate to a receiving substrate, the transfer method comprising:
an energy irradiation step for irradiating an active energy ray toward the element through the transfer substrate in a state in which the transfer substrate and the receiving substrate face each other across the element, to cause the element to detach from the transfer substrate and move to the receiving substrate,
the transfer substrate having a blistering layer in which a blister is generated due to irradiation of the active energy ray and the element being held by the blistering layer,
the receiving substrate having a capture layer that can hold the element and the capture layer being arranged facing the transfer substrate, and
in the energy irradiation step, the blister being formed in an element holding area, which is an area of the blistering layer that holds one element, to change a tilt of the element relative to the transfer substrate and to bring the element closer to the receiving substrate, thereby causing a portion of the element to come in contact with the capture layer first, in a state in which the blistering layer holds the element.

11. A transfer method for transferring an element held on a transfer substrate to a receiving substrate, the transfer method comprising:
an energy irradiation step for irradiating an active energy ray toward the element through the transfer substrate in a state in which the transfer substrate and the receiving substrate face each other across the element, to cause the element to detach from the transfer substrate and move to the receiving substrate,
the transfer substrate having a blistering layer in which a blister is generated due to irradiation of the active energy ray and the element being held by the blistering layer,
the receiving substrate having a capture layer that can hold the element and the capture layer being arranged facing the transfer substrate, and
in the energy irradiation step, a large blister and a small blister having different volumes being formed in an element holding area, which is an area of the blistering layer that holds one element, so as to be connected to each other, and gas inside the small blister moving into the large blister so that the large blister expands toward the receiving substrate, thereby causing the element to come in contact with the capture layer, in a state in which the blistering layer holds the element.
